**Europäisches Patentamt**

**European Patent Office**

**Office européen des brevets**

(11) Veröffentlichungsnummer: **0 632 299 A2**

## (12) EUROPÄISCHE PATENTANMELDUNG

(21) Anmeldenummer: **94109390.8**

(22) Anmeldetag: **17.06.94**

(51) Int. Cl.6: **G02B 6/12, H01S 3/085**

(30) Priorität: **03.07.93 DE 4322164**

(43) Veröffentlichungstag der Anmeldung:
**04.01.95 Patentblatt 95/01**

(84) Benannte Vertragsstaaten:
**DE ES FR GB IT NL**

(71) Anmelder: **ANT Nachrichtentechnik GmbH**
**Gerberstrasse 33**
**D-71522 Backnang (DE)**

(72) Erfinder: **Hillmer, Hartmut, Dr.**
**Peter-Behrens-Strasse 12**
**D-64287 Darmstadt (DE)**

(54) **Optoelektronisches Bauelement mit Rückkopplungsgitter.**

(57) 2.1. Die Erfindung dient der Optimierung der Kenngrößen von auf DFB-oder DBR-Gittern basierenden optoelektronischen Bauelementen.

2.2. Erfindungsgemäß liegt lateral zentral in longitudinaler Richtung (z-Richtung, axiale Richtung) ein Folge von gitterfreien Teilbereichen, an die lateral zwei DFB- oder DBR-Gitterbereiche angrenzen, die wiederum lateral außen von gitterfreien Teilbereichen begrenzt werden, wobei die vier lateralen Gitterbegrenzungen in Form von kontinuierlich verlaufenden Krümmungen ausgebildet sind. Dabei wird durch die gezielte geometrische Ausbildung der Gitterbereiche und der gitterfreien Bereiche sowie durch die Wahl des vertikalen Brechungsindexverlaufs die laterale Wellenführung erheblich unterstützt.

2.3 Die erfindungsgemäße Lösung läßt sich insbesondere vorteilhaft bei optoelektronischen Bauelementen, wie Lasern, Laserverstärkern, Filtern, Kopplern und Schaltern einsetzen.

EP 0 632 299 A2

Die Erfindung dient der Optimierung der Kenngrößen von auf DFB- oder DBR-Gitter basierenden optoelektronischen Bauelementen, wie beispielsweise Lasern, Laserverstärkern, Filtern, Kopplern und Schaltern.

Eine Gruppe von bekannten Lösungen beinhaltet die Erzeugung einer Variation des Kopplungskoeffizienten in axialer Richtung.

So wurde beispielsweise eine abrupte Änderung des Kopplungskoeffizienten in longitudinaler Richtung des Bauelements durch partielle Photolack-Remaskierung nach einer Teiltrockenätzung des DFB-Gitters erreicht [z.B. M. Matsuda et al., Conference on InP and related compounds (1991)].

Eine kontinuierliche axiale Variation des Kopplungskoeffizienten K wurde durch eine Doppelbelichtung einer auf einer Wafer-Oberfläche aufgetragenen Photolackschicht erreicht. Der Photolack enthält nach der Doppel-Belichtung die Information zweier sich überlagernder und sich durchdringender homogener DFB-Gitter, welche sich in ihrer Gitterperiode allerdings um $\Delta\Lambda$ unterscheiden. [A. Talneau et al., Electron. Lett. 28, 1395 (1992)]. Dieses Verfahren ermöglicht abhängig von der Wahl von $\Delta\Lambda$ jeweils nur eine vollständig definierte Funktion K(z) sowie genau eine dazu korrespondierende Bauelementelänge L, wenn die Periodizität der Struktur in Hinblick auf hohe Bauelementausbeute genutzt wird. Die Vorteile, welche eine beliebige Änderung von K(z) bietet, können mit diesem Verfahren nicht genutzt werden.

Eine andere Gruppe bekannter Lösungen beinhaltet die Erzeugung von Phasenverschiebungen über die axiale Verlängerung einer einzigen oder einer kleinen Zahl von Gitterperioden.

Abhängig von der Höhe der Kopplungskoeffizienten erzeugt eine abrupte Phasenverschiebung in DFB-Gittern verschieden starke Photonenzahl-Überhöhungen am Ort der Phasenverschiebung/en, welche manche Eigenschaften optoelektronischer Komponenten negativ beeinflussen können. Realisiert werden können abrupte Phasenverschiebungen durch holographische Verfahren [z.B. T. Numai et al, Jap. J. Appl. Phys. 26, L 1910 (1987)] oder mittels Elektronenstrahl-Lithographie (EL).

Die starke Photonenzahl-Überhöhung am Ort z. B. einer $\lambda/4$ Phasenverschiebung kann durch das Aufteilen des gesamten Phasenverschiebungs-Betrags auf mehrere örtlich voneinander getrennte Phasenverschiebungs-Anteile (engl. multiple phase-shifts) etwas abgeschwächt werden [z.B. S. Ogita et al. J. Ligthwave Technol 8, 1596 (1990)]. Die einzelnen Teil-Phasenverschiebungen wurden jedoch auch hierbei mittels Elektronenstrahl-Lithographie oder holographischer Methoden abrupt ausgeführt.

Desweiteren sind Lösungen bekannt, bei denen die Erzeugung von Phasenverschiebungen über die axiale Variation des effektiven Brechungsindex erfolgt.

So werden Phasenverschiebungen beispielsweise auch über eine laterale Aufweitung oder Verengung der Streifenbreite der aktiven Zone bzw. der aktiven Zone und benachbarter Schichten über eine bestimmte Länge der longitudinalen Bauelementelänge realisiert [z.B. H. Soda et al., IEEE J. Quant. electron. QE-23, 804 (1987), oder G. Chen et al. Appl. Phys. Lett. 60, 2586 (1992)]. Dabei wurde der effektive Brechungsindex in longitudinaler Richtung quasi abrupt geändert. Dies führt zu unerwünschten zusätzlichen optischen Vielfachreflektionen und optischen Interferenzeffekten an den Stellen, an denen sich der Brechungsindex abrupt ändert. Ferner wurden die Vorteile, welche eine beliebig auf einen längeren Teilabschnitt verteilte kontinuierliche Phasenverschiebung bietet, bei weitem nicht ausgeschöpft.

Eine weitere bekannte Lösung beinhaltet eine mit der z-Richtung lineare Änderung der lateralen Streifenbreite der aktiven Schicht und benachbarter Schichten über einen longitudinalen Teilabschnitt des Bauelements, um die Phasenverschiebung örtlich zu verteilen [z.B. Y. Nakano et al., IEEE J. Q. Electron. 24, 2017 (1988), oder J. Kinoshita et al. IEEE J. Q. Electron. 27, 1759 (1991)]. Nicht alle Vorteile, welche eine beliebige, kontinuierliche Verteilung der Phasenverschiebung bietet, wurden genutzt.

Bekannt ist weiterhin die sinusförmige Brechungsindex-Variation mittels in axialer Richtung variierter Streifenbreite. Diese Lösung wurde theoretisch vorgeschlagen, um eine vollständige Einmodigkeit zu erreichen [K. Tada et al. Electron. Lett. 20, 82 (1984)].

Desweiteren ist eine Lösung zur Erzeugung von Phasenverschiebungen bekannt, die auf einer Aufweitung der vertikalen Dicke der aktiven Schicht oder benachbarter Wellenleiterschichten über eine bestimmte Länge der longitudinalen Bauelementelänge beruht [z.B. B. Broberg, et al. Appl. Phys. Lett. 47, 4 (1985) oder K. Kojima et al. J. Lightwave Technol. LT-3, 1048 (1985)]. Dies führt zu unerwünschten zusätzlichen optischen Vielfachreflektionen und optischen Interferenzeffekten an den Stellen, an denen sich der Brechungsindex abrupt ändert. Ferner wurden die Vorteile, welche eine beliebig auf einen längeren Teilabschnitt verteilte kontinuierliche Phasenverschiebung ermöglicht, bei weitem nicht ausgeschöpft.

Weitere bekannte Lösungen beinhalten die Erzeugung einer Phasenverschiebung über die axiale Variation der Gitterperiode.

In der Literatur sind Beispiele für die abrupte Änderungen der Gitterperiode in axialer Bauelementerichtung angeführt. In der zentral gelegenen Sektion des Laser Resonators wurde holographisch eine größere Gitterperiode realisiert als in den Seitensektionen. Diese Struktur konnte erfolgreich zur Reduktion der optischen Linienbreite genutzt werden [M. Okai et al., IEEE J. Quantum Electron. 27, 1767 (1991)]. Der mittlere Bereich geänderter Gitterperiode dient der Erzeugung der Phasenverschiebung. Es wurden mit dieser Struktur abrupte Gitterperioden-Änderungen erzeugt. Es wurden jedoch nicht alle Vorteile, welche eine kontinuierliche Variation des Kopplungskoeffizienten bietet, ausgeschöpft.

In gewissem Rahmen ermöglicht auch EL die Realisierung von im Ortsraum verteilten Phasenverschiebungen über die Änderung der Gitterperiode in longitudinaler Richtung. Allerdings ist bei diesem Verfahren die Differenz zwischen benachbarten Gitterperioden auf größere Werte begrenzt. Dadurch können mit EL lediglich DFB-Gitter hergestellt werden, welche eine kleine Anzahl verschiedener Sektionen aufweisen, innerhalb denen die Gitterperiode konstant ist, sich jedoch von Sektion zu Sektion unterscheidet. Es können keine quasi-kontinuierlichen Variationen der Gitterperiode mit dem Ort erreicht werden. Ferner ist EL ein kompliziertes Verfahren und die EL-Schreibzeit ist sehr teuer.

Gekrümmte Wellenleiter auf homogenen DFB- oder DBR-Gitterfeldern können, wie bereits bekannt, zur Definition von Gittern mit axial variierter Gitterperiode genutzt werden. Mit dieser Methode können auch definierte Phasenverschiebungen über eine gezielte axiale Variation der Gitterperiode erzeugt werden und gleichzeitig die Phasenverschiebungen axial beliebig und quasi-kontinuierlich verteilt werden.

Die erfindungsgemäße Lösung dient der Optimierung der Kenngrößen des optoelektronischen Bauelements unter Vermeidung der beschriebenen Nachteile der bekannten Lösungen.

Die erfindungsgemäße Lösung betrifft optoelektronische Bauelemente, welche eine derart periodisch strukturierte Grenzfläche zwischen zwei Halbleiter-Schichten enthalten, daß eine optische Rückkopplung des geführten Lichtes entsteht (DFB- oder DBR-Gitter; DFB = distributed feedback, DBR = distributed Bragg reflector). Wichtigstes Merkmal der Struktur ist das besonders angeordnete DFB- oder DBR-Gitter, wobei die verteilte Rückkopplung durch ein in longitudinaler Richtung periodisches, geätztes Materialgitter realisiert wird, so daß eine periodische Variation des Real- und/oder Imaginärteils des Brechungsindex erreicht wird. Der Kern des optoelektronischen Bauelements besteht hierbei aus mindestens drei verschiedenen Halbleiter-Schichtpaketen, die in vertikaler Richtung (y-Richtung) auf dem Halbleitersubstrat übereinander aufgebracht sind. Jedes dieser Halbleiter-Schichtpakete ist in y-Richtung nicht notwendigerweise homogen, sondern kann auch seinerseits wieder aus verschiedenen Einzelschichten oder aus kontinuierlichen Übergängen zwischen verschiedenen Halbleiter-Schichten aufgebaut sein. Jedes Halbleiter-Schichtpaket wird daher im folgenden vereinfachend auch als Quasi-Einzelschicht benannt, d. h. mit dem Begriff "Halbleiter-Schicht" bezeichnet. Die zweite Halbleiter-Schicht enthält bei dieser Ausführungsform die laseraktive/n Halbleiter-Schicht/en, d. h. die Halbleiter-Schicht/en mit dem höchsten Brechungsindex.

Die Bezeichnung Halbleiter-Schicht beinhaltet im Falle der laseraktiven zweiten Halbleiter-Schicht z.B. auch eine Anzahl von Potentialtöpfen (quantum wells) und eine dementsprechende Anzahl von Potentialbarrieren. Im folgenden ist unter dem Brechungsindex einer Halbleiter-Schicht der innerhalb dieses Halbleiter-Schichtpakets gemittelte Brechungsindex zu verstehen. Unterhalb der ersten Halbleiter-Schicht ist das Halbleitersubstrat angeordnet. Das vertikale Dotierungsprofil der Struktur ist nach bekannten Halbleiterlaser-Design-Prinzipien ausgestaltet, so daß sich der pn-Übergang in der Nähe oder in der aktiven zweiten Halbleiter-Schicht befindet. Dabei ist sowohl n-leitendes als auch p-leitendes Halbleitersubstrat anwendbar.

Das Gitter weist in axialer = longitudinaler Richtung (z-Richtung) eine konstante Gitterperiode $\Lambda$, eine konstante Gittergrabentiefe a und ein konstantes Tastverhältnis W/$\Lambda$ auf (0<W<$\Lambda$), erstreckt sich jedoch in lateraler Richtung (x-Richtung) nicht über die gesamte Bauelemente-Breite, sondern weist charakteristische Begrenzungen auf. Diese Gitterbegrenzungen trennen die zwei Bereiche mit Gittergräben, die sich über die gesamte longitudinale Länge des optoelektronischen Bauelements erstrecken können, von den gitterfreien Bereichen ab. Von den gitterfreien Bereichen liegt einer lateral zentral zwischen den beiden Bereichen mit Gittergräben, die anderen lateral außerhalb der Bereiche mit Gittergräben.

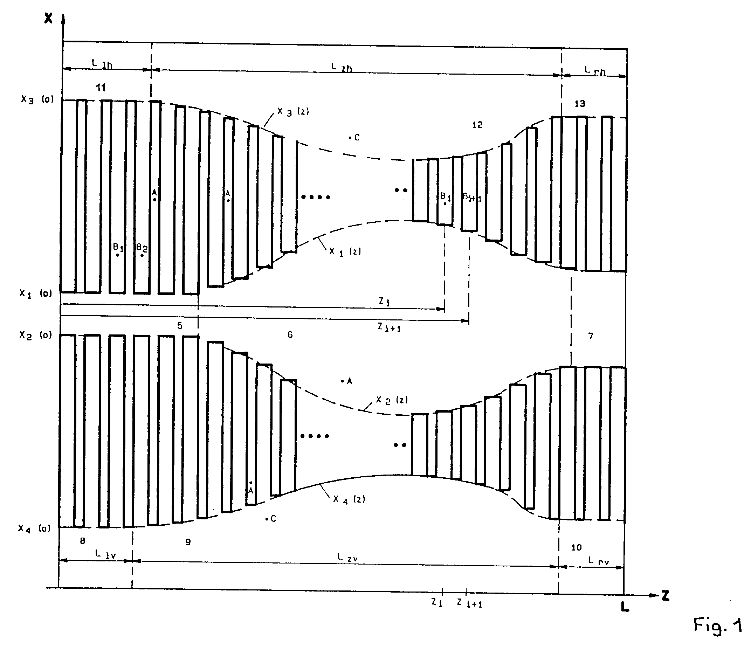

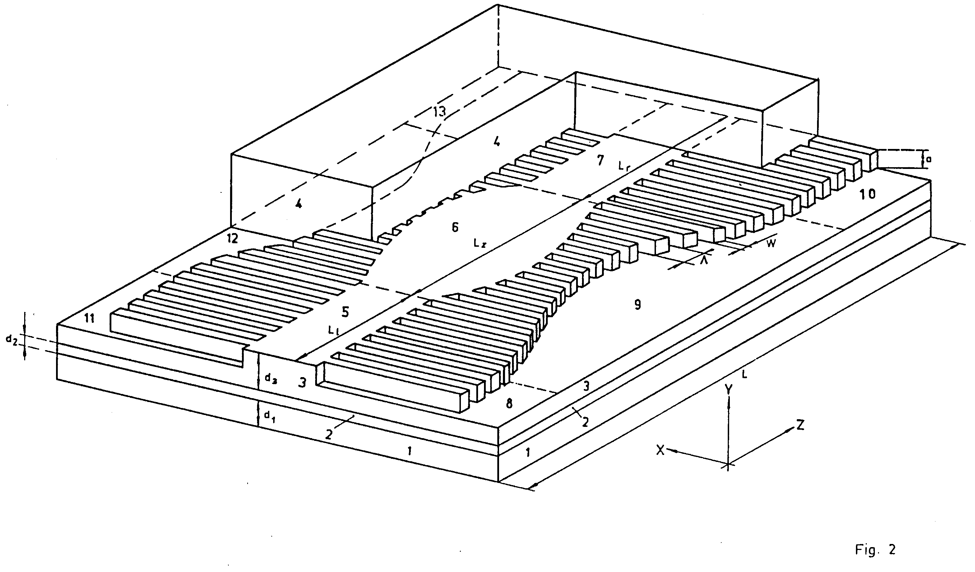

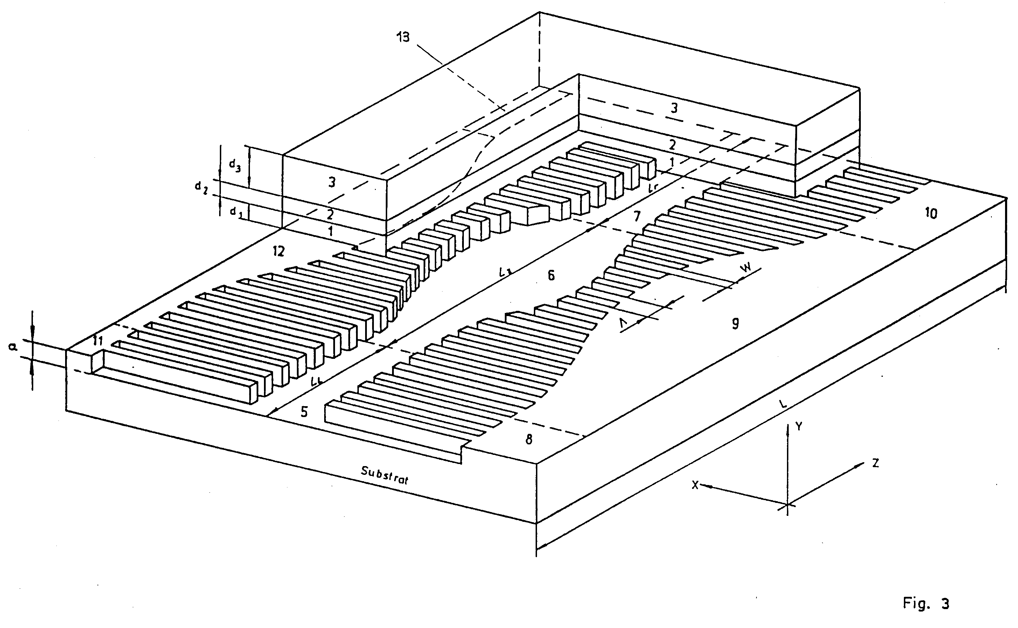

Erfindungsgemäß ist der lateral-zentrale, gitterfreie Bereich so ausgebildet, daß er sich aus einer über die gesamte Bauelementelänge durchgehenden Folge von gitterfreien Teilbereichen 5; 6; 7 zusammensetzt (siehe Fig. 1). Auch die lateral außen liegenden gitterfreien Bereiche sind in longitudinaler Richtung aus einer durchgehenden Folge von gitterfreien Teilbereichen 8; 9; 10 und 11; 12; 13 zusammengesetzt. Die lateral zentral liegenden gitterfreien Teilbereiche 5,6 und 7 sind bezüglich ihrer lateralen Breite unterschiedlich ausgebildet, wobei die gitterfreien Teilbereiche, die in Zonen des optoelektronischen Bauelements angeordnet sind, in denen die Intensität des geführten Lichtfeldes deutlich von Null verschieden ist und die demzufolge in der Nähe des in den Schnitt-Ebenen senkrecht zur z-Richtung jeweils ermittelten Intensitätsmaximums des geführten Lichtfeldes liegen, Gitterbegrenzungen in Form von kontinuierlich verlaufenden Krümmungen aufweisen, die durch ihre in longitudinaler Richtung quasi-kontinuierlich variierende laterale Position gekennzeichnet sind. Ebenso variiert die laterale Breite der Bereiche mit Gittergräben in longitudinaler Richtung, da jeder der Bereiche mit Gittergräben laterale Begrenzungen aufweist, welche kontinuierlich gekrümmt ausgeführt sind.

Je nach angestrebter Anwendung des optoelektronischen Bauelements wird mittels rechnerischer Optimierung die Bauelemente-Geometrie, die Brechungsindizes der einzelnen Halbleiter-Schichten, sowie insbesondere die mathematischen Funktionen, die den Verlauf der Gitterbegrenzungen charakterisieren, ermittelt. Durch die in longitudinaler Richtung quasi-kontinuierlich variierende laterale Breite der Bereiche mit Gittergräben und der gitterfreien lateralzentralen Teilbereiche 5;6;7, die in Zonen des optoelektronischen Bauelements angeordnet sind, in denen die Intensität des geführten Lichtfeldes deutlich von Null verschieden. ist, wird eine definierte und quasi-kontinuierliche Änderung des lateralen effektiven Brechungsindex und des Kopplungskoeffizienten erreicht.

Die erfindungsgemäße Lösung wird anhand eines Ausführungsbeispiels näher erläutert:

Figur 1     zeigt eine Variation der vier lateralen Gitterbegrenzungen $x_1(z)$; $x_2(z)$; $x_3(z)$ und $x_4(z)$

Figur 2     zeigt ein Beispiel für die erfindungsgemäße Ausbildung der Gitterbegrenzungen unter Verwendung einer Halbleiterstruktur mit vier Halbleiter-Schichten

Figur 3     zeigt ein Beispiel für die erfindungsgemäße Ausbildung der Gitterbegrenzungen unter Verwendung einer Halbleiterstruktur mit drei Halbleiter-Schichten

Figur 4     stellt den Verlauf des vertikalen Brechungsindex $n_{eff,y}$ als Funktion der lateralen Richtung x an zwei verschiedenen Stellen z, sowie die Positionen der auch in Fig.1 verwendeten Punkte A;B und C dar. Es wird der Fall gezeigt, in dem sich die laseraktive Halbleiter-Schicht über den gesamten in lateraler Richtung dargestellten Bildbereich erstreckt.

In Figur 2 ist ein Beispiel für ein erfindungsgemäß ausgebiletes optoelektronisches Bauelement abgebildet, dessen Bauelementekern aus vier verschiedenen Halbleiter-Schichten 1 bis 4 besteht, welche in vertikaler Richtung, y-Richtung, übereinander auf dem Halbleitersubstrat angeordnet sind. Jede dieser Halbleiter-Schichten ist in y-Richtung nicht notwendigerweise homogen, sondern kann auch ihrerseits wieder aus verschiedenen Einzelschichten oder aus kontinuierlichen Übergängen zwischen verschiedenen Halbleiter-Schichten aufgebaut sein. Die Halbleiter-Schicht 2 enthält die aktive/n Schicht/en, d. h. die Schicht/en mit höchstem Brechungsindex.

Der Brechungsindex der Halbleiter-Schichten 3 und 1 ist jeweils kleiner als derjenige der Halbleiter-Schicht 2. Ferner ist der Brechungsindex der Halbleiter-Schicht 4 kleiner als derjenige der Halbleiter-Schicht 3. Unterhalb der Halbleiter-Schicht 1 liegt das Halbleitersubstrat, das in Fig. 2 aus Gründen der Übersichtlichkeit nicht dargestellt ist. Das vertikale Dotierungsprofil der Struktur ist nach bekannten Halbleiterlaser-Design-Prinzipien zu wählen, so daß sich der pn-Übergang in der Nähe der aktiven Halbleiter-Schicht 2 oder in der aktiven Halbleiter-Schicht 2 befindet.

Wichtigstes Merkmal der Struktur ist ein besonders angeordnetes DFB- oder DBR-Gitter, welches in longitudinaler Richtung, z-Richtung, eine konstante Gitterperiode aufweist, sich jedoch in lateraler Richtung (x-Richtung) nicht über die gesamte Bauelemente-Breite erstreckt, sondern mehrere charakteristische Gitterbegrenzungen aufweist. Die lateral zentralen Gitterbegrenzungen definieren besonders ausgebildete gitterfreie Teilbereiche 5,6 und 7 in den lateral zentralen Zonen des Bauelements, in denen die Lichtintensität des geführten Lichtfeldes deutlich von Null verschieden ist. Betrachtet man in Fig. 2 die vorn liegende Frontfläche in der xy-Ebene, so liegt die Maximalintensität des geführten Lichtfeldes dieser als Beispiel herausgegriffenen Fläche in der Nähe der Grenzfläche zwischen Halbleiter-Schicht 2 und 3 unterhalb der Mitte der vornliegenden Begrenzungslinie des ersten gitterfreien Teilbereichs 5. Für die Wirksamkeit des vorgeschlagenen Prinzips ist dabei sehr wichtig, daß die Gitter und deren innere Begrenzungen einen genügend großen Überlapp mit dem geführten Lichtfeld aufweisen und somit nicht zu weit vom Intensitätsmaximum in den Schnittebenen senkrecht zur z-Richtung entfernt liegen dürfen. Die lateralen Begrenzungen des gitterfreien Teilbereichs 6 sind durch Funktionen $x_1 = x_1(z)$ und $x_2 = x_2(z)$ beschrieben. Die laterale Breite $[x_1(z) - x_2(z)]$ des gitterfreien Teilbereichs 6 variiert in longitudinaler Richtung auf einer Länge $L_z$, während die laterale Breite $[x_1(z) - x_2(z)]$ auf den gitterfreien Teilbereichen 5 und 7, über die Längen $L_l$ und $L_r$, jeweils konstant ist. Die Gesamtlänge des optoelektronischen Bauelements ist mit L bezeichnet. Die Gitterbereiche weisen jedoch in lateraler Richtung außen ebenfalls gekrümmt verlaufende Gitterbegrenzungen $x_3 = x_3(z)$ und $x_4 = x_4(z)$ auf. Dadurch variiert die laterale Breite der Bereiche mit Gittergräben aufgrund der jeweils auf beiden Seiten gekrümmt verlaufenden Gitterbegrenzungen $x_1(z)$ und $x_3(z)$ bzw. $x_2(z)$ und $x_4(z)$. Die Stegbreite des Gitters ist durch W und die Tiefe der Gittergräben ist durch a angegeben. Die verschiedenen Bereiche mit Gittergräben und die verschiedenen gitterfreien Bereiche werden jeweils bei der Herstellung der Gitter definiert, d.h. bei der Definition des Höhen- und Tiefenprofils der Grenzfläche zwischen der dritten und vierten Halbleiter-Schicht 3; 4. Dabei bleibt der gitterfreie Bereich, der zwischen den Gitterbereichen angeordnet ist, in vertikaler Richtung ungeätzt. In den Bereichen mit Gittergräben bleibt entsprechend dem Tastverhältnis in longitudinaler Richtung das Halbleitermaterial an den Gitterstegen stehen. Die dazwischenliegenden Gittergräben werden auf die gewünschte Tiefe a geätzt. Die Tiefe der Gittergräben a variiert je nach Dimensionierung des gesamten Bauelements zwischen einem Betrag, welcher kleiner als die gesamte vertikale Schichtdicke der dritten Halbleiter-Schicht 3 ist und einem Betrag, welcher noch etwas größer als die Summe aus der vertikalen Schichtdicke der Halbleiter-Schicht 2 und der doppelten vertikalen Schichtdicke der dritten Halbleiter-Schicht $[d_2 + 2d_3]$ sein kann. In dem Fall, in dem wie in Fig. 2 dargestellt, lateral außen liegend gitterfreie Teilbereiche 8; 9; 10 und 11; 12; 13 vorhanden sind, wird in diesen Teilbereichen ebenfalls durch Ätzen ein in der xz-Ebene ganzflächiger Materialabtrag vorgenommen, der in seiner Tiefe der jeweiligen vertikalen Tiefe der Gittergräben a entspricht. Anschließend werden alle Bereiche ganzflächig mit einem Halbleiter-Material (Halbleiter-Schicht 4), das einen kleineren Brechungsindex aufweist als die Halbleiter-Schicht 3, überwachsen.

Im Prinzip muß die aktive Zone nicht wie in Fig. 2 unterhalb der Gitterebene liegen, sondern kann, wie in Fig.3 aufgezeigt, in dem Fall, in dem drei Halbleiter-Schichten 1; 2; 3 über dem Halbleitersubstrat liegen, ebenso darüber angeordnet sein. Bei dieser Ausführungsform besteht der Kern des optoelektronischen Bauelements aus drei in vertikaler Richtung auf dem Halbleitersubstrat aufgebrachten Halbleiter-Schichten 1; 2 und 3, wobei ausgehend vom Halbleitersubstrat mit dem Gitter die zweite Halbleiter-Schicht 2 ebenfalls die Schicht/en mit dem höchsten Brechungsindex enthält. Der Brechungsindex der ersten und der dritten Halbleiter-Schicht 1 und 3 ist dabei kleiner als der Brechungsindex der zweiten Halbleiter-Schicht 2. Das vertikale Dotierungsprofil der Struktur ist ebenfalls nach bekannten Halbleiterlaser-Design-Prinzipien ausgestaltet, so daß sich der pn-Übergang in der Nähe oder in der aktiven zweiten Halbleiter-Schicht 2 befindet. Dabei ist sowohl n-leitendes als auch p-leitendes Halbleitersubstrat anwendbar. Die Gitterbereiche weisen auch in diesem Fall kontinuierlich gekrümmt verlaufende Gitterbegrenzungen $x_1(z)$; $x_2(z)$; $x_3(z)$ und $x_4(z)$ auf. Die laterale Breite des in Fig. 3 linken Gitterbereichs ist durch $[x_1(z) - x_3(z)]$ gegeben und variiert in longitudinaler Richtung. Die laterale Breite des rechten Gitterbereichs ist durch $[x_2(z) - x_4(z)]$ gegeben und variiert ebenfalls in longitudinaler Richtung. Dadurch ändert sich in longitudinaler Richtung auch die laterale Breite $[x_1(z) - x_2(z)]$ des lateral zentral liegenden gitterfreien Bereichs. In diesem Fall wird die Festlegung der einzelnen Bereiche bei der Definition des Höhen- und Tiefenprofils der Grenzflächen zwischen dem Halbleitersubstrat und der ersten Halbleiter-Schicht 1 vorgenommen. Der lateral-zentrale gitterfreie Bereich zwischen den Gitterbereichen wird in vertikaler Richtung jeweils um einen Betrag, welcher der jeweiligen Gittertiefe a entspricht abgeätzt. In den Gitterbereichen bleibt entsprechend dem Tastverhältnis in longitudinaler Richtung das Halbleitermaterial an den Gitterstegen stehen. Die dazwischen liegenden Gittergräben werden auf die gewünschte Tiefe a geätzt. Die Tiefe der Gittergräben a kann dabei zwischen Null und $[d1 + d2]$ variieren.In dem Fall, in dem das optoelektronische Bauelement lateral außen liegende gitterfreie Bereiche besitzt, bleiben diese Bereiche stehen, d. h., sie werden nicht weiter behandelt. Im Anschluß daran werden alle Bereiche ganzflächig mit einem Halbleitermaterial (Halbleiter-Schicht 1) mit größeren Brechungsindex, als derjenige des Halbleitersubstrats überwachsen. Dabei muß ein planarisierendes Epitaxieverfahren angewendet werden. Dabei überträgt sich das in das Halbleitersubstrat geätzte Höhen- und Tiefenprofil überhaupt nicht oder nicht in voller Stärke auf die nachgeordneten Halbleiter-Schichten 1, 2 und 3. Das bedeutet, daß die Grenzflächen zwischen den Halbleiter-Schichten 1 und 2 bzw. 2 und 3 nicht dasselbe Profil aufweisen, wie die Grenzflächen zwischen dem Halbleitersubstrat und der ersten Halbleiter-Schicht 1, sondern in der xz-Ebene geglättet oder idealerweise nahezu eben verläuft.

Entscheidend für das vorgeschlagene Bauelement ist die mathematische Form der Krümmungskurven der Gitterbegrenzungen $x_1(z)$; $x_2(z)$; $x_3(z)$ und $x_4(z)$. Ganz besonderes Gewicht kommt dabei den Funktionen $x_1 = x_1(z)$ und $x_2 = x_2(z)$ zu, welche die Bereiche mit Gittergräben von den gitterfreien Teilbereichen abtrennen (siehe Fig.1; 2 u. 3). Durch die quasi-kontinuierlich in longitudinaler Richtung variierende laterale Breite der Gitterbegrenzungen $[x_1(z) - x_2(z)]$ der gitterfreien Teilbereiche 5;6 und 7 wird eine definierte und quasi-kontinuierliche Änderung des effektiven Brechungsindex und des Kopplungskoeffizienten erreicht. Durch entsprechende Wahl der Form der Gitterbegrenzungen $x_1 = x_1(z)$; $x_2 = x_2(z)$; $x_3 = x_3(z)$ und $x_4 = x_4(z)$ können verschiedenartigste Verteilungen des effektiven Brechungsindex in longitudinaler Richtung, z-Richtung, erreicht werden. Die gitterfreien Teilbereiche 5 und 7 mit den Teillängen $L_l$ und $L_r$, auf denen sich, wie in Fig. 2 und 3 abgebildet, die Differenz der lateralen Breite $[x_1(z) - x_2(z)]$ nicht ändert, können im Grenzfall auch die Länge Null haben, bzw. auch in der Mitte des Bauelements der Gesamtlänge L liegen. Die beiden Krümmungen der Gitterbegrenzungen $x_1 = x_1(z)$ und $x_2 = x_2(z)$ sind nicht notwendigerweise spiegelbildlich zueinander ausgebildet, wie in Fig. 1, 2 und 3 dargestellt. Die Differenz des lateralen Abstands x der Gitterbegrenzungen $[x_1(z) - x_2(z)]$ kann im Prinzip an jeder beliebigen Stelle in longitudinaler Richtung z ihren Minimalwert annehmen. Eine Verjüngung der beiden Bereiche mit Gittergräben in ihrem mittleren Bereich führt ebenso wirkungsvoll zu einer definierten Phasenverschiebung und einer Variation des Kopplungskoeffizienten, siehe Fig. 1;2 und 3, wie eine entsprechende Verbreiterung der Bereiche mit Gittergräben. Je nach angestrebter Anwendung des optoelektronischen Bauelements muß eine rechnerische Optimierung der Bauelemente-Geometrie, der Brechungsindex-Werte, sowie insbesondere der mathematischen Funktionen der Gitterbegrenzungen $x_1 = x_1(z)$; $x_2 = x_2(z)$; $x_3 = x_3(z)$ und $x_4 = x_4(z)$ durchgeführt

werden.

In Figur 1, 2 und 3 werden jeweils wichtige Teile eines optoelektronischen Bauelements mit DFB-Gitter dargestellt. Es ist jedoch auch die Verwendung von DBR-Gittern möglich, in denen es in longitudinaler Richtung ebenfalls völlig gitterfreie Bereiche gibt. Die laseraktive Halbleiter-Schicht 2 muß sich nicht zwangsläufig in lateraler Richtung x über die gesamte Bauelemente-Fläche erstrecken. Sie muß jedoch in jedem Fall unter bzw. über den zentralen gitterfreien Teilbereichen 5, 6 und 7 liegen. Die Strominjektion in die aktive Halbleiter-Schicht wird lateral gesehen auf jene Teile der laseraktiven Schicht begrenzt, welche nahe dem Maximum des geführten Lichtes liegen. Elektrisch gepumpt wird somit nur ein Streifen mit einer Länge von etwa L und einer lateralen Breite, die etwas größer oder von vergleichbarer Größe wie das Maximum von $[x_1(z)-x_2(z)]$ ist, welches im Bereich $0 < z < L$ liegt. Die laterale Ausführung der laseraktiven Schicht, sowie die Ermöglichung der Strominjektion kann nach bekannten Bauelemente-Design Prinzipien erfolgen, z.B. in Form einer vergrabenen Laserstruktur (buried heterostructure) oder einer Rippenstruktur (ridge structure).

Die zahlenmäßige Größe des Kopplungskoeffizienten K wird vor allem bestimmt durch die Tiefe der Gittergräben a, den lokalen lateralen Abstand der Gitterbegrenzungen $[x_1(z) - x_2(z)]$ voneinander, sowie durch das Tastverhältnis $W/\Lambda$ und in geringerem Maße auch durch den Verlauf von $x_3(z)$ und $x_4(z)$. Der lokale Kopplungskoeffizient ergibt sich rechnerisch aus dem lokalen Überlapp der Gitterbereiche mit der Lichtintensitäts-Verteilung in den xy-Schnittebenen an den Stellen $z_i$ im Bauelement. Die Wellenführung (Intensitätsverteilung des geführten Lichtes in der xy-Ebene) wird durch Lösung der Maxwellschen Gleichungen mit Randbedingungen für die Zentralwellenlänge des Bauelements ermittelt. Die Zentralwellenlänge ist z.B. die angestrebte Bragg-Wellenlänge eines Ein-Sektions-DFB-Lasers oder z. B. die Wellenlänge, um die herum in einem Mehr-Sektions-Bauelement eine Wellenlängenabstimmung erfolgen soll. Die Wellenführung in der xy-Ebene wird durch die Brechungsindex-Variation in dieser Ebene festgelegt. Die vertikalen Dicken und die Brechungsindizes der einzelnen Halbleiter-Schichten werden so gewählt, daß bei einer Zentralwellenlänge eine gute Wellenführung erreicht wird, unter Berücksichtigung der lateralen Dimensionen der einzelnen Halbleiter-Schichten und deren lateralen Brechungsindex-Variationen, die insbesondere auch durch $x_1(z)$; $x_2(z)$; $x_3(z)$ und $x_4(z)$ gegeben ist.

Die Berechnung des Betrags der Phasenverschiebung aus dem mathematischen Verlauf $x_1(z)$; $x_2(z)$; $x_3(z)$ und $x_4(z)$ läßt sich über verschiedene Methoden realisieren.

Eine mögliche Methode stellt eine Näherungslösung dar, die durch das sequenzielle rechnerische Lösen mehrerer eindimensionaler Wellengleichungs-Probleme charakterisiert ist. Dazu notwendige Arbeitsschritte werden an Fig.1 und an den Ausführungsbeispielen in Fig. 2 und 3 erläutert:

1. Berechnung der Wellenführung in y-Richtung für die Zentral-Wellenlänge [siehe z. B. S. Hansmann, J. Ligthwave Technol. 10, 620 (1992)]:

a) An einer Stelle A (Siehe Figur 1).

Im Ausführungsbeispiel in Fig. 2 ist an den Punkten A bei der Strukturierung der Halbleitergrenzfläche, in welcher das Gitter liegt, kein Materialabtrag der Halbleiterschicht 3 durch Ätzen erfolgt. D. h., die Punkte A liegen in den lateral zentral liegenden gitterfreien Teilbereichen oder auf den Gitterstegen. Im Ausführungsbeispiel in Fig. 3 ist an den Punkten A bei der Strukturierung der Halbleitergrenzfläche, in welcher das Gitter liegt, ein Materialabtrag im Halbleitersubstrat durch Ätzen erfolgt. D. h., die Punkte A liegen, wie in Fig. 3 dargestellt, in den lateral
zentral liegenden gitterfreien Teilbereichen oder in den Gittergräben.

In die Rechnung gehen die einzelnen Schichtdicken in y-Richtung und die entsprechenden Brechungsindizes ein. Aus der Rechnung resultiert ein effektiver vertikaler Brechungsindex $n_{eff,y}$ (A). An allen Punkten A liegt derselbe vertikale effektive Brechungsindex vor, wenn sich die aktive Halbleiter-Schicht 2, wie in Fig. 2 und 3 dargestelit, über die in den Abbildungen gezeigte laterale Breite erstreckt.

b) Für eine bestimmte Gittergraben-Tiefe a an einer Stelle B.

An den Punkten B existiert im Ausführungsbeispiel in Figur 2 ein Gittergraben und im Ausführungsbeispiel in Fig. 3 ein Gittersteg. Daraus resultiert an allen Stellen $B_i$ derselbe effektive Brechungsindex $n_{eff,y}$ (B) in y-Richtung, wenn sich die aktive Halbleiter-Schicht 2, wie in Fig. 2 und 3 dargestellt, über die in den Abbildungen dargestellte laterale Breite erstreckt.

c) An einer Stelle C, welche lateral außerhalb der zwei Bereiche mit Gittergräben liegt $[x > x_3(z)$ oder $x < x_4(z)]$.

Im Ausführungsbeispiel in Fig. 2 liegt an den Punkten C, die Grenzfläche zwischen der dritten und der vierten Halbleiterschicht 3; 4 überall in der xz-Ebene um den Betrag der Gittertiefe a tiefer als im lateral zentral liegenden gitterfreien Bereich. Im Ausführungsbeispiel in Fig. 3 ist an den Punkten C an der Halbleitergrenzfläche, in welcher das Gitter liegt, kein Materialabtrag im Halbleiter-Substrat durch Ätzen erfolgt.

Es ist daher der vertikale effektive Brechungsindex $n_{eff,y}(C) = n_{eff,y}(B)$, wenn die aktive Halbleiterschicht 2 sich wie in Fig. 2 und 3 über die gesamte dargestellte laterale Breite erstreckt.

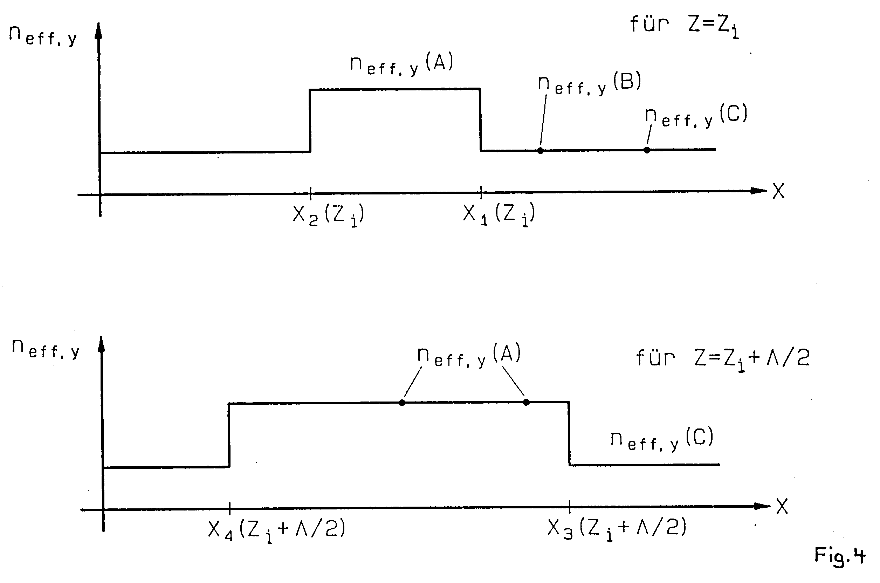

2. Berechnung der Wellenführung in x-Richtung für die Zentral-Wellenlänge an allen Stellen $B_1...B_j...B_p$, unter Berücksichtigung der Ergebnisse von Punkt 1. Dabei ist p die Gesamtzahl der Gittergräben im Bauelement. (Die Gräben auf den beiden Seiten der gitterfreien Teilbereiche 5, 6 und 7 werden dabei nicht doppelt gezählt). Längs eines Schnitts durch die Stelle $B_i$ (d. h. für $z = z_i$) beträgt der Brechungsindex, wie in Fig.4 (oben) abgebildet, in x-Richtung:

$= n_{eff,y} (C)$ für $x > x_3(z_i)$

$= n_{eff,y} (B)$ für $x_3(z_i) \geq x \geq x_1(z_i)$

$= n_{eff,y} (A)$ für $x_1(z_i) > x > x_2(z_i)$

$= n_{eff,y} (B)$ für $x_2(z_i) \geq x \geq x_4(z_i)$.

$= n_{eff,y} (C)$ für $x_4(z_i) > x$

Längs eines Schnittes bei $z = z_i + \Lambda/2$ verläuft der Brechungsindex, wie in Fig. 4 unten abgebildet, in x-Richtung:

$= n_{eff,y} (C)$ für $x > x_3(z_i)$

$= n_{eff,y} (A)$ für $x_3(z_i + \Lambda/2) \geq x \geq x_1(z_i + \Lambda/2)$

$= n_{eff,y} (A)$ für $x_1(z_i) > x > x_2(z_i)$

$= n_{eff,y} (A)$ für $x_2(z_i + \Lambda/2) \geq x \geq x_4(z_i + \Lambda/2)$

$= n_{eff,y} (C)$ für $x_4(z_i) > x$

In die Rechnung geht entscheidend die Breite $[x_1(z) - x_2(z)]$ der zentralen Schicht ein, welche den Brechungsindex $n_{eff,y}$ (A) aufweist. Aus der Rechnung resultiert im Prinzip an jeder Stelle $z_i$ ein unterschiedlicher Brechungsindex $n_{eff,xy}(z_i,a)$. Durch die quasi-kontinuierlichen Funktionen $x_1 = x_1(z_i)$, $x_2 = x_2(z_i)$, $x_3 = x_3(z_i)$ und $x_4 = x_4(z_i)$ ergibt sich somit eine quasi-kontinuierliche axiale Änderung des Brechungsindex $n_{eff,xy}(z_i,a)$. Falls sich die laseraktive Halbleiter-Schicht nicht über die gesamte laterale Bauelementebreite erstreckt, ist die im Unterpunkt 2 beschriebene Aufteilung um zwei weitere Grenzver-läufe $x_5(z)$ und $x_6(z)$ zu erweitern, welche den lateralen Rand der laseraktiven Halbleiter-Schicht wiedergeben.

Eine weitere Methode der Berechnung des Betrags der Phasenverschiebung aus dem mathematischen Verlauf $x_1(z)$, $x_2(z)$, $x_3(z)$ und $x_4(z)$ beruht auf einem effektiv zweidimensionalen Wellengleichungsmodell an allen Punkten $B_i$. In die Rechnung geht der Brechungsindex-Verlauf in allen xy-Ebenen ein, welche durch die Punkte $B_i$ gehen und als Normale die z-Achse besitzen. Die rechnerische Lösung dieses Problems ist wesentlich komplizierter, führt jedoch unmittelbar zu den Werten $n'_{eff,xy} (z_i,a)$. Diese Rechnung wird an allen Punkten $B_1...B_i...B_p$ durchgeführt.

Die Ergebnisse des ersten Verfahrens stellen eine Näherungslösung der präziseren Ergebnisse des zweiten Verfahrens dar. Im Folgenden wird zwischen $n'_{eff,xy} (z_i,a)$ und $n_{eff,xy} (z_i,a)$ nicht unterschieden.

Für die Definition der Phasenverschiebung gibt es zwei Möglichkeiten: erstens, der Bezug auf eine Vergleichsphase, welche für feste Werte von a, sowie festgehaltene Funktionen $x_1(z)$; $x_2(z)$; $x_3(z)$ und $x_4(z)$ mit dem minimalen Wert $n_{eff,xy} (z_j) = n_{eff,mi}$ mathematisch verknüpft ist oder zweitens, der Bezug auf eine Vergleichsphase, welche mit dem maximalen Wert $n_{eff,xy}(z_j) = n_{eff,ma}$ mathematisch zusammenhängt. Dabei ist $n_{eff,ma}$ der maximale und $n_{eff,mi}$ der minimale Wert von allen $n_{eff,xy} (z_j)$, welche in longitudinaler Richtung an den Punkten $z_j$ vorkommen. Mögliche Werte j sind ganzzahlig und liegen im Bereich $1 \leq j \leq p$. Im folgenden steht $n_{eff,m}$ für $n_{eff,ma}$ oder $n_{eff,mi}$. Die Phasenverschiebung $\Delta\phi_w$, welche an der Stelle $z_i$ innerhalb einer Gitterperiode erzeugt wird gegenüber einer mit $n_{eff,m}$ verknüpften Gitterperiode, errechnet sich nach

$$\Delta\varphi_w = \pi - \left(\frac{W}{\Lambda} \cdot \frac{n_{eff,xy}(z_i)}{n_{eff,m}} - 1\right) \qquad (1)$$

Die gesamte Phasenverschiebung des Gitters ergibt sich aus der Summe der Phasenverschiebungsanteile jeder einzelnen Gitterperiode.

$$\Delta\varphi \;=\; \sum_{i=1}^{p}\; \pi\; \frac{W}{\Lambda}\; \left(\frac{n_{eff,xy}(z_i)}{n_{eff,m}} \;-\; 1\right) \tag{2}$$

Der Abstand $[x_1(z) - x_2(z)]$ kann zwischen $0,1\mu m$ und $5\mu m$, je nach Anforderung an das Bauelement, durch entsprechende Wahl der Funktionen $x_1(z)$ und $x_2(z)$ gewählt werden. Der Abstand $[x_3(z) - x_4(z)]$ kann zwischen $1\mu m$ und dem zwanzigfachen der Zentralwellenlänge liegen. Es gilt dabei jedoch immer $x_3(z) > x_1(z)$ und $x_2(z) > x_4(z)$. Falls bei dem Bauelement laterale Einmodigkeit bei der Zentralwellenlänge erwünscht ist, muß bei der Dimensionierung auf einen genügend großen Unterschied bezüglich des "optical confinement" zwischen der lateralen Grundmode und der nächst höheren lateralen Mode geachtet werden. Je weniger die Differenz $[x_1(z) - x_2(z)]$ in longitudinaler Richtung variiert wird, um so größer muß für eine festgehaltene Phasenverschiebung die Tiefe der Gittergräben a gewählt werden. Beispiel: Zur Realisierung z. B. einer $\lambda/4$ Phasenverschiebung sorgt man durch Wahl der Funktionen $x_1 = x_1(z)$; $x_2 = x_2(z)$; $x_3 = x_3(z)$ und $x_4 = x_4(z)$ sowie der Brechungsindizes und der vertikalen Dicken der einzelnen Schichten dafür, daß $\Delta\phi = \pi/2$ wird.

Die Tiefe der Gittergräben a und die lokale Differenz $[x_1(z) - x_2(z)]$ bestimmen überwiegend die lokale Größe des Kopplungskoeffizienten K an der Stelle z. Der Kopplungskoeffizient hängt ferner ab von dem Tastverhältnis $W/\Lambda$, den Funktionen $x_1 = x_1(z)$; $x_2 = x_2(z)$; $x_3 = x_3(z)$ und $x_4 = x_4(z)$ und dem detailierten vertikalen Schichtaufbau (Dicke der einzelnen Halbleiter-Schichtpakete und deren Brechungsindizes). Je kleiner die Differenz der Gitterbegrenzungen $[x_1(z) - x_2(z)]$ und je tiefer die Gittergräben, um so größer ist jeweils der Kopplungskoeffizient K.

Die laterale Wellenführung wird durch die vorgeschlagene Struktur insbesondere des Höhen- und Tiefenprofils der Grenzfläche, in welcher das Gitter liegt, automatisch unterstützt und herbeigeführt. (siehe Fig. 2, 3 und 4). Die laterale Wellenführung ist dabei um so größer, je größer der Brechungsindex-Unterschied auf beiden Seiten des Gitters ist und je größer die Gittertiefe a ist. Ferner hängt die laterale Wellenführung stark von der lateralen Position der Gitterbegrenzungen $x_1(z)$, $x_2(z)$, $x_3(z)$ und $x_4(z)$ ab. Dabei ist der Beitrag von den äußeren lateralen Begrenzungen der Gitter $x_3(z)$ und $x_4(z)$ zur lateralen Wellenführung nur spürbar, wenn diese so plaziert werden, daß sie in dem Bereich angeordnet sind, in dem das geführte Lichtfeld noch nennenswerte Intensität besitzt.

Da bei dem vorgeschlagenen optoelektronischen Bauelement das Gitter selbst zur lateralen Wellenleitung beiträgt, ist bei einer Ausführung des Bauelements als "ridge Struktur" (Rippen-Struktur) die Dimensionierung des Abstandes des Gitters vom vertikalen unteren Ende der Rippe wesentlich unkritischer, was die Technologie wesentlich erleichtert. Insbesondere kann der eben erwähnte Abstand durch die erfindungsgemäße Lösung größer gewählt werden und die vertikale Höhe der Rippe kleiner dimensioniert werden. Die Rippe verläuft dabei typischerweise über die gesamte longitudinale Bauelementelänge L und ist in der lateralen Breite vergleichbar oder etwas größer als der Maximalwert von $[x_1(z) - x_2(z)]$, welcher im Bereich $0 \leq z \leq L$ vorkommt. Lateral gesehen verläuft die Rippe oberhalb des lateral zentral liegenden gitterfreien Bereichs.

Die erfindungsgemäße Lösung ermöglicht eine kontinuierliche Verteilung der Phasenverschiebung eines DFB-Gitters (z. B. Verteilung einer $\lambda/4$-Phasenverschiebung über beispielsweise $L_z = 300\mu m$ bei einer Bauelementelänge von $L = 600\mu m$). Dadurch wird die starke Photonenzahl-Überhöhung am Ort einer abrupten Phasenverschiebung und damit deren negative Auswirkungen auf gewisse Bauelemente-Kenngrößen vermieden.

Die in der axialen Variation des effektiven Brechungsindex $n_{eff,xy}(z_i,a)$ enthaltenen Parameter (insbesondere $x_1(z)$, $x_2(z)$, $x_3(z)$, $x_4(z)$, a, $W/\Lambda$, die einzelnen Schichtdicken, deren laterale Ausdehnungen und deren Brechungsindizes), können optimiert werden, um Kenngrößen des optoelektronischen Bauelements zu verbessern. Erzielt werden können für einen Halbleiterlaser beispielsweise gleichzeitig einer oder mehrere der folgenden Vorteile:

- kleinere spektrale Linienbreiten der optischen Emission
- reduziertes räumliches Lochbrennen und damit Verbesserung der longitudinalen Einmoden-Stabilität
- bessere Hochfrequenzeigenschaften, wie reduzierter Frequenz-Chirp und höhere Grenzfrequenzen unter hochfrequenter Modulation
- stabilere longitudinale Einwelligkeit bei hoher Ausgangsleistung
- mögliche Schwellenstrom-Erniedrigung der Hauptmode und mögliche Schwellenstrom-Erhöhung der Seitenmoden.

Weiterhin wird mittels der erfindungsgemäßen Lösung eine äußerst präzise Einstellung des Betrags der Phasenverschiebung, sowie der Verteilung der Phasenverschiebung in longitudinaler Richtung erreicht.

Der effektive Brechungsindex kann im Bereich der Bauelemente-Teillänge, welche die Phasenverschiebung enthält, nach nahezu beliebigen mathematischen Funktionen variiert werden. Die mathematischen Funktionen definieren dabei die Form der Gitter-Begrenzungen in der Nähe des Intensitäts-Maximums der optisch geführten Lichtwelle.

**Patentansprüche**

1. Optoelektronisches Bauelement mit Rückkopplungsgitter, mit axial quasi-kontinuierlich und nahezu beliebig variierbarem Gitter-Kopplungskoeffizienten, mit quasikontinuierlich axial verteilbarer Brechungsindex-Variation, sowie mit axial nahezu beliebig verteilbarer und variierbarer Phasenverschiebung, dessen Bauelementekern aus dem Halbleitersubstrat und aus mindestens drei in vertikaler Richtung übereinander angeordneten Halbleiter-Schichten besteht, daß die zweite Halbleiter-Schicht die aktive/n Schicht/en und den innerhalb der gesamten Schichtenfolge höchsten Brechungsindex aufweist, daß das Gitter entweder über oder unter der zweiten Halbleiter-Schicht angeordnet ist, daß die optische Rückkopplung des geführten Lichtes dadurch entsteht, daß eine oder mehrere Halbleiter-Schichten derart strukturiert sind, daß eine periodische Variation des Real- und/oder Imaginärteils des Brechungsindexes in axialer Bauelementerichtung existiert, und daß sich im Gitter zwischen den Bereichen mit Gittergräben über die gesamte Länge des optoelektronischen Bauelements ein gitterfreier Bereich erstreckt, wobei die beidseitig der gitterfreien Bereiche angeordneten Bereiche mit Gittergräben in axialer Richtung über die gesamte Bauelementelänge jeweils eine konstante Gitterperiode, ein konstantes Tastverhältnis und eine konstante Gittergraben-Tiefe aufweisen, **dadurch gekennzeichnet,** daß der gitterfreie Bereich zwischen den zwei Gitterbereichen aus einer in longitudinaler Richtung durchgehenden Folge von gitterfreien Teilbereichen besteht, die in longitudinaler Richtung variierend unterschiedliche laterale Breiten aufweisen, daß die gitterfreien Teilbereiche, die in Zonen des optoelektronischen Bauelements angeordnet sind, in denen die Intensität des geführten Lichtes deutlich von Null verschieden ist und die in der Nähe des in den Schnitt-Ebenen senkrecht zur z-Richtung jeweils ermittelten Intensitätsmaximums des geführten Lichtes liegen, Gitterbegrenzungen zu den Bereichen mit Gittergräben aufweisen, die in Form von Krümmungen mit quasi-kontinuierlich in longitudinaler Richtung variierender lateraler Position ausgebildet sind, daß die konkrete Form der Gitterbegrenzungen und die konkrete Tiefe der Gittergräben, das Tastverhältnis, die Bauelementegeometrie und der vertikale Brechungsindex-Verlauf über mathematische Methoden festgelegt werden, wobei gilt, je kleiner die Differenz des lateralen Abstandes zwischen den Gitterbegrenzungen, welche die zentralen gitterfreien Bereiche einschließen, um so größer der Kopplungskoeffizient.

2. Optoelektronisches Bauelement nach Anspruch 1, dadurch gekennzeichnet, daß die in longitudinaler Richtung (z) durchgehend angeordneten und lateral zentral liegenden Gitterbegrenzungen, die durch die Funktionen $x_1 = x_1(z)$ und $x_2 = x_2(z)$ definiert sind und die den gesamten gitterfreien lateral zentral liegenden Bereich von den Teilbereichen mit Gittergräben lateral abgrenzen, in ihrer Form so ausgebildet sind, daß der gesamte lateral zentral liegende gitterfreie Bereich in drei sich über die gesamte Bauelementelänge (L) erstreckende gitterfreie Teilbereiche (5;6;7) unterteilt ist, daß dabei die laterale Breite $[x_1(z)-x_2(z)]$ des ersten gitterfreien Teilbereichs (5), auf ihrer gesamten Teillänge ($L_l$) in longitudinaler Richtung (z) konstant ist, daß die laterale Breite $[x_1(z)-x_2(z)]$ des zweiten gitterfreien Teilbereichs (6) auf ihrer gesamten Teillänge ($L_z$) einer quasi-kontinuierlich in longitudinaler Richtung variierenden lateralen Veränderung unterliegt, die durch die mathematische Form der kontinuierlich verlaufenden Krümmungen der beiden Gitterbegrenzungen $x_1(z)$ und $x_2(z)$ zwischen dem gitterfreien Teilbereich (6) und den beiden Teilbereichen mit Gittergräben definiert ist, und daß die laterale Breite $[x_1(z)-x_2(z)]$ des dritten gitterfreien Teilbereichs (7), in Analogie zur lateralen Breite $[x_1(z)-x_2(z)]$ des ersten Teilbereichs (5), in longitudinaler Richtung (z) auf ihrer gesamten Teillänge ($L_r$) konstant ist.

3. Optoelektronisches Bauelement nach Anspruch 1 und 2, dadurch gekennzeichnet, daß die zwei Teilbereiche mit Gittergräben jeweils auf ihrer den zentralen gitterfreien Teilbereichen (5;6 und 7) abgewandten Seite durch die Funktionen $x_3 = x_3(z)$ und $x_4 = x_4(z)$ definierte zusätzliche Gitterbegrenzungen aufweisen, die entsprechend ihrer Zuordnung die zwei Teilbereiche mit Gittergräben von beidseitig lateral außen angeordneten gitterfreien Teilbereichen (8;9 und 10) und (11;12 und 13) abgrenzen, daß die außen angeordneten Gitterbegrenzungen ebenfalls in Form von Krümmungen mit quasi-kontinuierlich in longitudinaler Richtung variierender lateraler Position ausgebildet sind, wobei die lateralen Breiten der Bereiche mit Gittergräben durch die Differenz $[x_3(z)-x_1(z)]$ bzw. durch die Differenz $[x_2(z)-x_4(z)]$ gekennzeichnet sind.

4. Optoelektronisches Bauelement nach Anspruch 1, 2 und 3, dadurch gekennzeichnet, daß der lateral zentrale gitterfreie Teilbereich (6), und/oder der gitterfreie Teilbereich (9) und/oder der gitterfreie Teilbereich (12), deren Gitterbegrenzungen kontinuierlich gekrümmt ausgebildet sind, an einem longitudinalen Ende des optoelektronischen Bauelements angeordnet sind.

5. Optoelektronisches Bauelement, nach Anspruch 1,2 und 3 dadurch gekennzeichnet, daß die Summe der longitudinalen Längen $(L_l;L_r)$ des ersten und des dritten lateral zentralen gitterfreien Teilbereichs (5;7) in longitudinaler Richtung (z) einen Betrag von Null aufweist.

6. Optoelektronisches Bauelement nach Anspruch 1,2 und 3, dadurch gekennzeichnet, daß die laterale Breite $[x_1(z)-x_2(z)]$ des ersten und des dritten gitterfreien Teilbereichs (5;7) in longitudinaler Richtung quasi-kontinuierlich variierend ausgebildet ist, und daß die laterale Breite des zweiten gitterfreien Teilbereichs (6) in longitudinaler Richtung konstant ist.

7. Optoelektronisches Bauelement nach Anspruch 1,2,3 und 4 dadurch gekennzeichnet, daß insbesondere die sich gegenüberliegenden Gitterbegrenzungen $x_1(z)$ und $x_2(z)$ des zweiten gitterfreien Teilbereiches (6) bezüglich ihrer mathematischen Form völlig unterschiedlich ausgebildet sind, wobei im Extremfall eine Gitterbegrenzung gekrümmt und die der gekrümmten Gitterbegrenzung gegenüberliegende Gitterbegrenzung ungekrümmt verläuft.

8. Optoelektronisches Bauelement nach Anspruch 1 bis 7, dadurch gekennzeichnet, daß das Gitter unterhalb der aktiven Halbleiter-Schicht (2) angeordnet ist.

9. Optoelektronisches Bauelement nach Anspruch 1 bis 7, dadurch gekennzeichnet, daß das Gitter oberhalb der aktiven Halbleiter-Schicht 2 angeordnet ist.

10. Optoelektronisches Bauelement nach Anspruch 8, dadurch gekennzeichnet, daß in dem Fall, in dem bei drei Halbleiter-Schichten (1;2;3) das Gitter unterhalb der zweiten Halbleiter-Schicht (2) angeordnet ist, die Tiefe der Gittergräben (a) in einem Bereich variierbar ist, welcher zwischen Null und der Summe der vertikalen Schichtdicke der ersten und der zweiten Halbleiter-Schicht (1;2) liegt.

11. Optoelektronisches Bauelement nach Anspruch 9, dadurch gekennzeichnet, daß in dem Fall, in dem bei vier Halbleiter-Schichten (1;2;3;4) das Gitter oberhalb der zweiten Halbleiter-Schicht (2) angeordnet ist, die Tiefe der Gittergräben (a) in einem Bereich variierbar ist, welcher kleiner als die vertikale Schichtdicke der dritten Halbleiter-Schicht (3), aber nicht viel größer als die Summe der vertikalen Schichtdicke der zweiten Halbleiter-Schicht (2) und der doppelten vertikalen Schichtdicke der dritten Halbleiter-Schicht (3) ist.

12. Optoelektronisches Bauelement nach Anspruch 1,2 und 3, dadurch gekennzeichnet, daß in die Struktur des optoelektronischen Bauelements mindestens fünf Halbleiter-Schichten integriert sind.

13. Optoelektronisches Bauelement nach Anspruch 1 bis 12 und 10 bis 11, dadurch gekennzeichnet, daß der vertikale effektive, Brechungsindex in den lateral zentral liegenden gitterfreien Teilbereichen größer ist, als der über eine quadratische Fläche der parallel zu den Gitterstegen liegenden Kantenlängen $2\Lambda$ gemittelte vertikale effektive Brechungsindex der Gitterfelder, daß der gemittelte vertikale effektive Brechungsindex der Gitterfelder wiederum größer ist, als der vertikale Brechungsindex der lateral außen liegenden gitterfreien Bereiche, wobei die Unterschiede der vertikalen effektiven Brechungsindizes einerseits durch die Strukturierung der Gitterebene, d.h. durch das Höhen- und Tiefenprofil der Halbleitergrenzfläche und andererseits durch die Brechungsindizes der beiden das Gitter einschließenden Halbleiterschichten gegeben sind, wodurch die laterale Wellenführung der Lichtwelle wesentlich unterstützt wird.

14. Optoelektronisches Bauelement nach Anspruch 5 bis 7, dadurch gekennzeichnet, daß die für die gitterfreien Teilbereiche (5, 6, 7) mit ihren Begrenzungen $x_1(z)$ und $x_2(z)$ formulierten geometrischen Anordnungen auch für die gitterfreien Teilbereiche (8, 9, 10) mit der Begrenzung $x_4(z)$ sowie für die gitterfreien Teilbereiche (11, 12, 13) mit der Begrenzung $x_3(z)$ gültig sind.

15. Optoelektronisches Bauelement nach Anspruch 1 bis 7, dadurch gekennzeichnet, daß die erste Halbleiter-Schicht (1) die aktive/n Schicht/en mit dem höchsten Brechungsindex enthält.

Fig. 1

EP 0 632 299 A2

Fig. 2

Fig. 3

für $Z = Z_i$

$n_{eff,y}(A)$

$n_{eff,y}(B)$

$n_{eff,y}(C)$

$X_2(Z_i)$   $X_1(Z_i)$

für $Z = Z_i + \Lambda/2$

$n_{eff,y}(A)$

$n_{eff,y}(C)$

$X_4(Z_i + \Lambda/2)$   $X_3(Z_i + \Lambda/2)$

Fig. 4

EP 0 632 299 A2